# EUROPEAN PATENT SPECIFICATION

(11) **EP 4 085 314 B1**
(45) Date of publication and mention of the grant of the patent: **20.08.2025**
(21) Application number: 20908718.8
(22) Date of filing: 02.01.2020
(51) Int. Cl.: G06F 1/16, A47B 21/04, A47B 21/06, G06F 1/18, F16M 11/08, F16M 11/20, F16M 13/02, G06F 1/26

(54) **COMPUTER DOCKING STATION**
COMPUTERANDOCKSTATION
STATION D'ACCUEIL D'ORDINATEUR

(43) Date of publication of application: 09.11.2022
(73) Proprietor: Humanscale Corporation, New York NY 10036 (US)
(72) Inventor: WONG, David, New York, NY 10016 (US)
(74) Representative: J A Kemp LLP
(86) International application number: PCT/US2020/012087
(87) International publication number: WO 2021/137868

(56) References cited:
- US-A1- 2004 014 349
- US-A1- 2007 139 870
- US-A1- 2013 071 176
- US-A1- 2015 282 352
- US-A1- 2016 352 054
- US-A1- 2017 060 209
- US-A1- 2018 024 607
- US-A1- 2018 217 636
- US-A1- 2018 287 322

## Description

### BACKGROUND

Advances in processors, battery life, and visual displays have vastly improved the performance possibilities of laptop computers. With wireless mobility and connectivity becoming a necessity in today's business environment, many businesses and entrepreneurs have chosen to use laptop computers in lieu of desktops in the workplace. However, laptops typically have smaller keyboards than the standard keyboards utilized with desktops, and a standard mouse is generally preferred by users in the office environment over the built-in touchpad or trackpad of laptop computers. In addition, prolonged use of a laptop alone can be an uncomfortable experience for the user.

A docking station allows laptop computers to become a substitute for a desktop computer without sacrificing the mobile computing functionality of the machine. For example, port replicator-type docking stations allow multiple peripherals-such as a keyboard, a printer, a mouse, and/or one or more monitors-to be connected to the laptop simultaneously by simply connecting the laptop to the docking station. Thus, the user can get access to an external full-sized keyboard, standard mouse, full-size monitor(s), a printer/scanner and a wired network connection when working in the office environment. Ergonomic positioning of the external keyboard and monitor allow the user to assume a more comfortable, neutral posture at the workstation, thus reducing the musculoskeletal stress typically associated with the prolonged use of laptop computers.

In a typical office configuration, the docking station will be located on the work surface to allow the user to easily connect the laptop to the dock. However, while this location provides the convenience of a quick and easy connection to the laptop, the docking station can take up valuable workspace, regardless of whether a vertical stand-alone docking station or a horizontal style docking station is utilized. Moreover, current generation docking stations positioned on the work surface leave the permanent cables exposed on the work surface, creating a cluttered work environment. US 2018/024607 A1 discloses a computer docking station. US 2015/282352 A1 discloses a docking mechanism for locking and undocking multiple electronic instruments.

### SUMMARY

The invention is defined in claim 1. Further aspects and preferred embodiments are defined in the dependent claims. Aspects, embodiments and examples of the present disclosure which do not fall under the scope of the appended claims do not form part of the invention and are merely provided for illustrative purposes. The invention disclosed herein is directed to a computer docking station devised to save desktop space while also eliminating the presence of permanent cables that can clutter the work surface. Whereas prior art computer docking stations typically are unitary units that take up valuable space on the work surface, the computer docking station of the present invention significantly reduces the docking station's desktop footprint by utilizing a split design, with a lower dock subassembly positioned beneath the work surface for housing the permanent cables necessary for the computer workstation to operate, and an upper dock subassembly comprising one or more data ports positioned on top of the work surface. In certain embodiments, a monitor arm mount can also be integrated into the upper dock subassembly, thereby alleviating the need for a separate monitor arm mount without negatively impacting the docking station's footprint. The split-design computer docking station of the present invention provides for improved accessibility to commonly used ports such as universal serial bus (USB) ports, high-speed charging port(s) and audio/microphone ports, while eliminating unsightly permanent cables (e.g., power, video, and network cables) from the desktop, which not only improves aesthetics and the amount of available desk space, but also eliminates the safety hazard of having cables on the work surface and prevents users from intentionally or unintentionally tampering with permanent cables.

The above summary is not intended to describe each illustrated embodiment or every possible implementation. These and other features, aspects, and advantages of the present invention will become better understood with regard to the following description, appended claims, and accompanying drawings.

### BRIEF DESCRIPTION OF THE DRAWINGS

The accompanying figures, where like reference numerals refer to identical or functionally similar elements throughout the separate views, which are not true to scale, and which, together with the detailed description below, are incorporated in and form part of the specification, serve to illustrate further various embodiments and to explain various principles and advantages in accordance with the present invention:
**Figure 1** is a front perspective view of an embodiment of a computer docking station.
**Figure 2** is a partially exploded view of the embodiment of the computer docking station shown in Figure 1.
**Figure 3** is a front perspective view of the embodiment of the computer docking station shown in Figure 1 wherein the computer docking station is mounted to a table.
**Figure 4** is a rear perspective view of the embodiment of the computer docking station shown in Figure 1 wherein the computer docking station is mounted to a table.
**Figure 5** is a front perspective view of an embodiment of the upper dock subassembly of the computer docking station shown in Figure 1.
**Figure 6** is an exploded view of an embodiment of the upper dock subassembly of the computer docking station shown in Figure 1.
**Figure 7** is a front view of an embodiment of the upper dock subassembly of the computer docking station shown in Figure 1.
**Figure 8** is a left side view of an embodiment of the upper dock subassembly of the computer docking station shown in Figure 1.
**Figure 9** is a right side view of an embodiment of the upper dock subassembly of the computer docking station shown in Figure 1.
**Figure 10** is a rear view of an embodiment of the upper dock subassembly of the computer docking station shown in Figure 1.
**Figure 11** is a front perspective view of an embodiment of the lower dock subassembly of the computer docking station shown in Figure 1.
**Figure 12** is an exploded view of an embodiment of the lower dock subassembly of the computer docking station shown in Figure 1.
**Figure 13** is a left side view of an embodiment of the lower dock subassembly of the computer docking station shown in Figure 1.
**Figure 14** is a right side view of an embodiment of the lower dock subassembly of the computer docking station shown in Figure 1.
**Figure 15** is a rear view of an embodiment of the lower dock subassembly of the computer docking station shown in Figure 1.
**Figure 16** is a front view of an embodiment of the lower dock subassembly of the computer docking station shown in Figure 1.
**Figure 17** is a front perspective view of the computer docking station shown in Figure 1 further comprising an embodiment of a cable management system attached to either side of the lower dock subassembly.
**Figure 18** is a partial rear perspective view of the cable management system shown in Figure 17.
**Figure 19** is an exploded rear perspective view of the cable management system shown in Figure 18.
**Figure 20** is a front perspective view of an alternative embodiment of a computer docking station embodying principles of the present invention wherein the computer docking station is mounted to a table.
**Figure 21** is a rear perspective view of the alternative embodiment of the computer docking station depicted in Figure 20.
**Figure 22** is a right side view of the alternative embodiment of the computer docking station depicted in Figure 20 wherein the removable data port hub of the upper dock subassembly is mounted to the mounting plate of the upper dock subassembly.
**Figure 23** is a right side view of the alternative embodiment of the computer docking station depicted in Figure 20 wherein the removable data port hub of the upper dock subassembly is removed from the mounting plate of the upper dock subassembly.
**Figure 24** is an exploded view of an embodiment of the upper dock subassembly of the computer docking station shown in Figure 20.

### DETAILED DESCRIPTION

Detailed embodiments of the present invention are disclosed herein; however, it is to be understood that the disclosed embodiments are merely exemplary of the invention, which can be embodied in various forms. Therefore, specific structural and functional details disclosed herein are not to be interpreted as limiting, but merely as a basis for the claims and as a representative basis for teaching one skilled in the art to variously employ the present invention in virtually any appropriately detailed structure. Alternate embodiments may be devised without departing from the scope of the invention. Further, the terms and phrases used herein are not intended to be limiting; but rather, to provide an understandable description of the invention. While the specification concludes with claims defining the features of the invention that are regarded as novel, it is believed that the invention will be better understood from a consideration of the following description in conjunction with the drawing figures, in which like reference numerals are carried forward.

As used herein, the terms "a" or "an" are defined as one or more than one. The term "plurality," as used herein, is defined as two or more than two. The term "another," as used herein, is defined as at least a second or more. The terms "comprises," "comprising," or any other variation thereof are intended to cover a non-exclusive inclusion, such that a process, method, article, or apparatus that comprises a list of elements does not include only those elements, but may include other elements not expressly listed or inherent to such process, method, article, or apparatus. An element proceeded by "comprises ... a" does not, without more constraints, preclude the existence of additional identical elements in the process, method, article, or apparatus that comprises the element. The terms "including," "having," or "featuring," as used herein, are defined as comprising (i.e., open language). The term "coupled," as used herein, is defined as connected, although not necessarily directly, and not necessarily mechanically. As used herein, the term "about" or "approximately" applies to all numeric values, whether or not explicitly indicated. These terms generally refer to a range of numbers that one of skill in the art would consider equivalent to the recited values (i.e., having the same function or result). In many instances these terms may include numbers that are rounded to the nearest significant figure. Relational terms such as first and second, top and bottom, right and left, and the like may be used solely to distinguish one entity or action from another entity or action without necessarily requiring or implying any actual such relationship or order between such entities or actions.

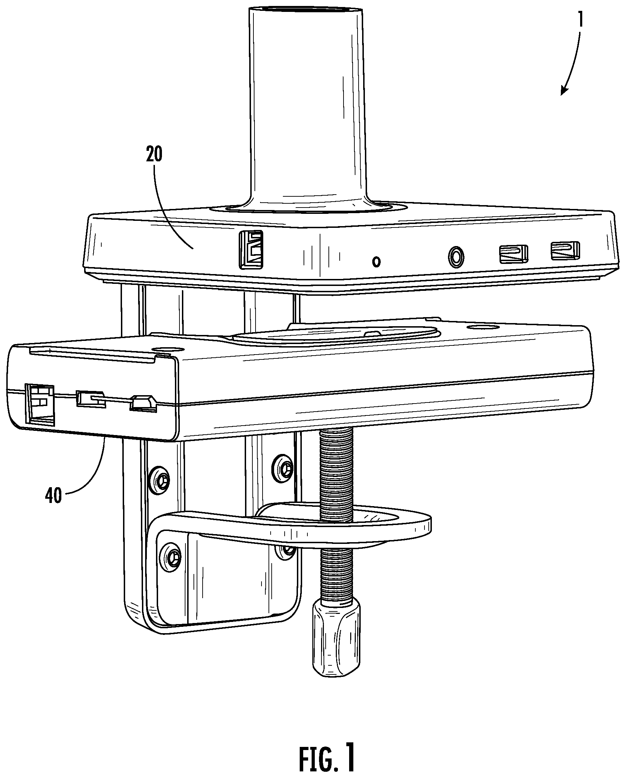

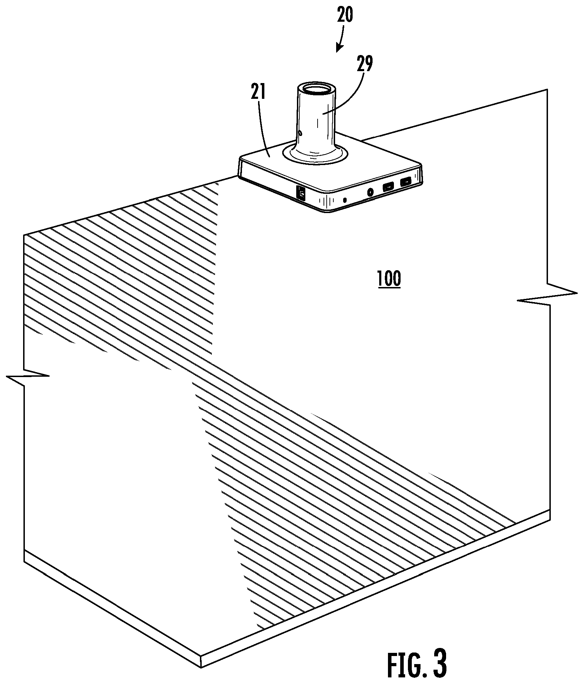

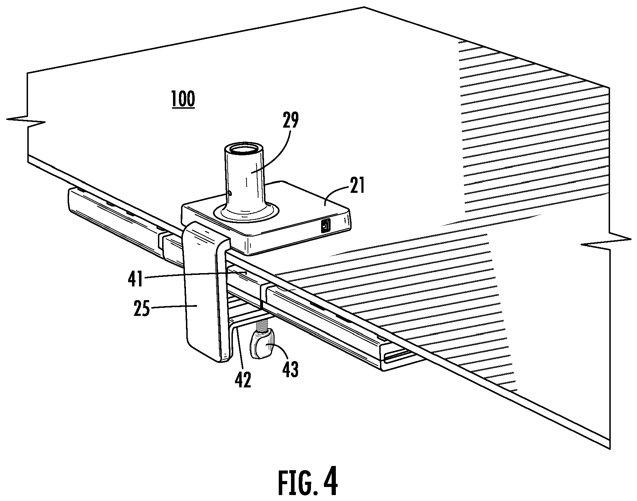

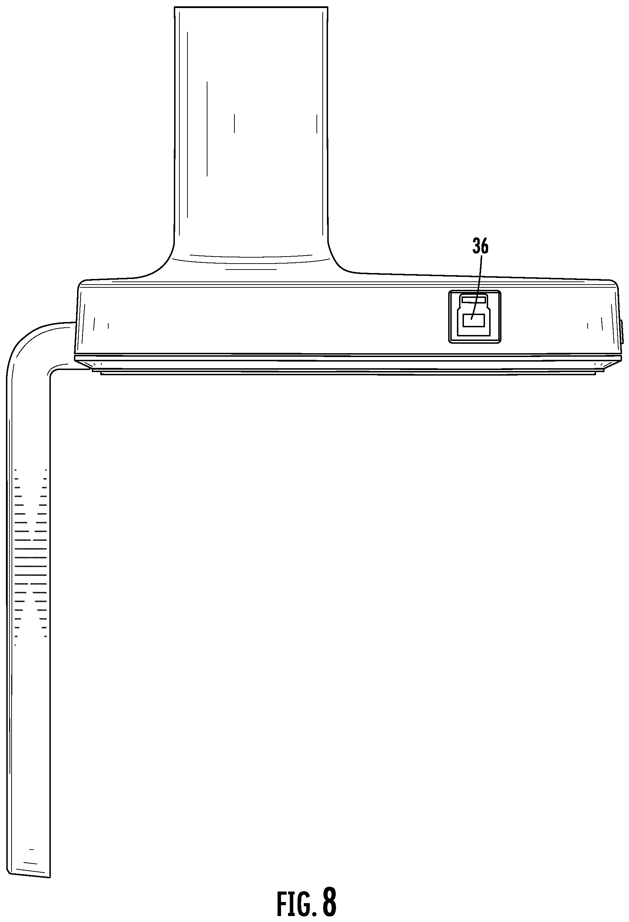

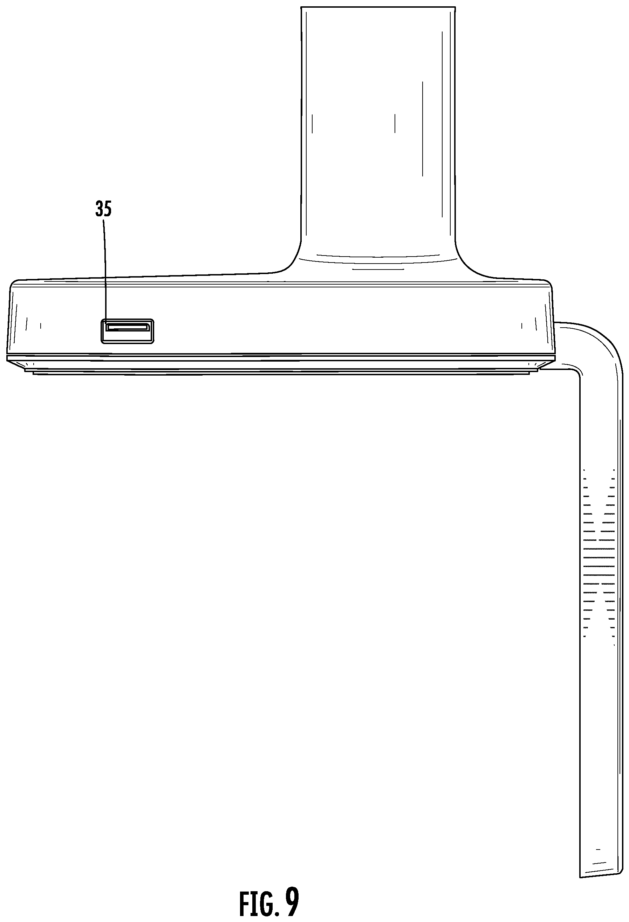

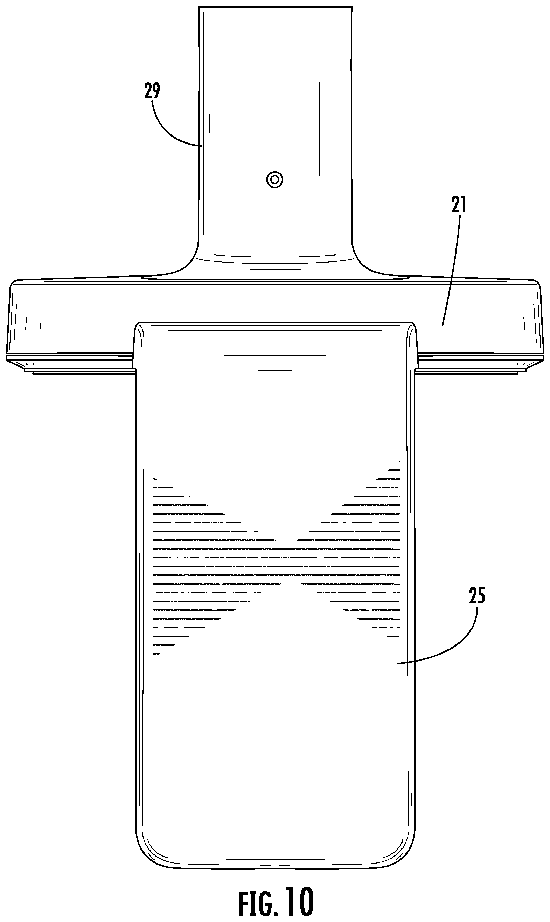

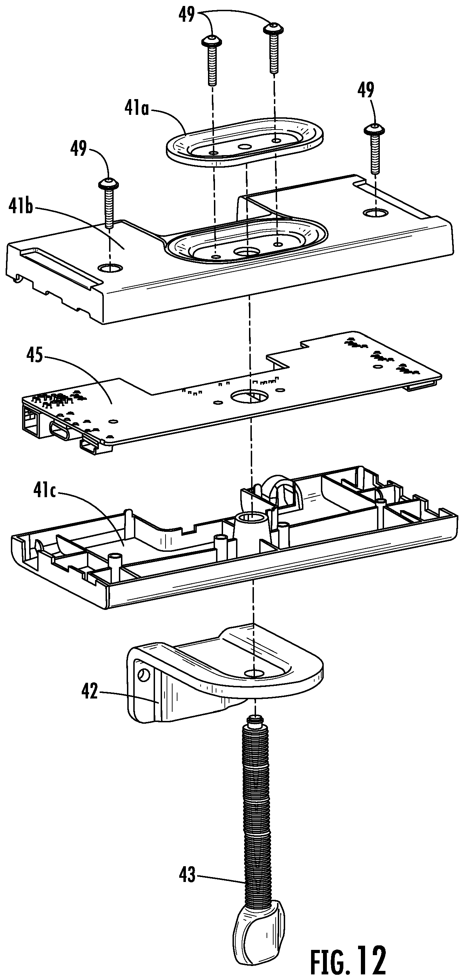

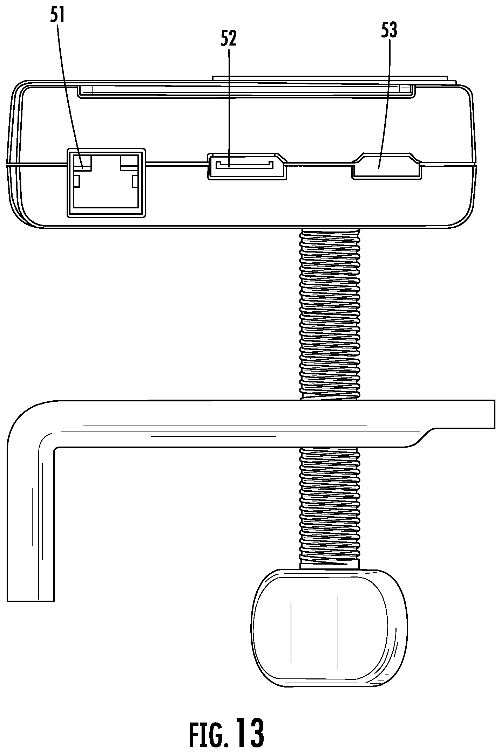

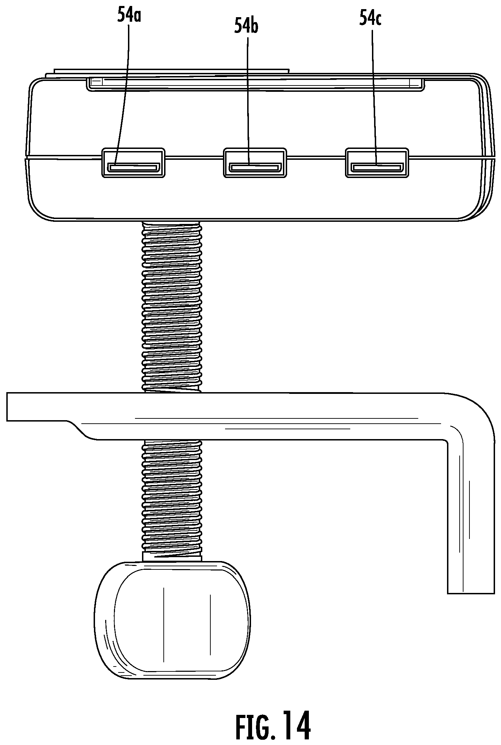

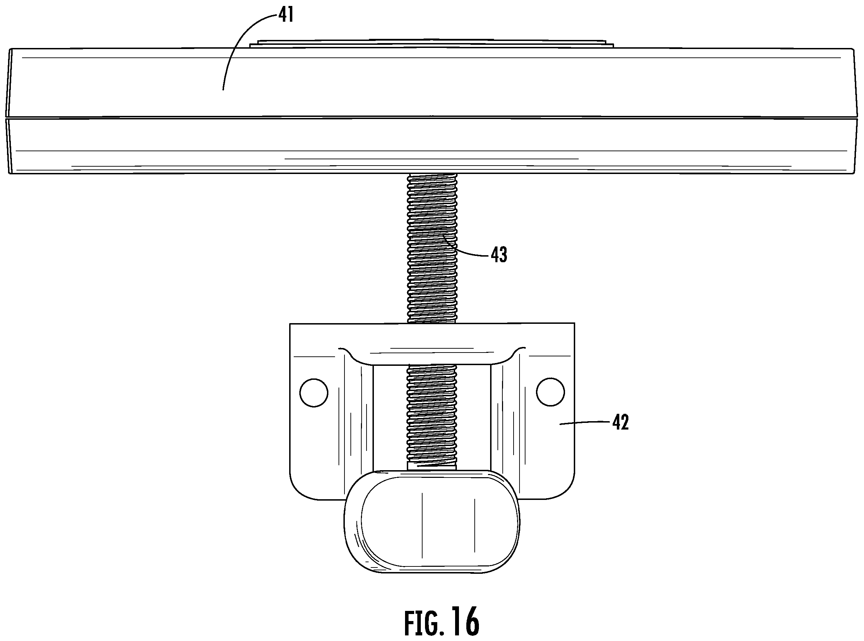

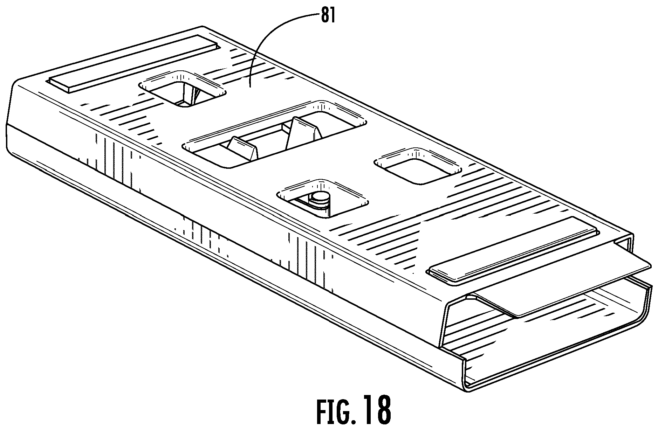

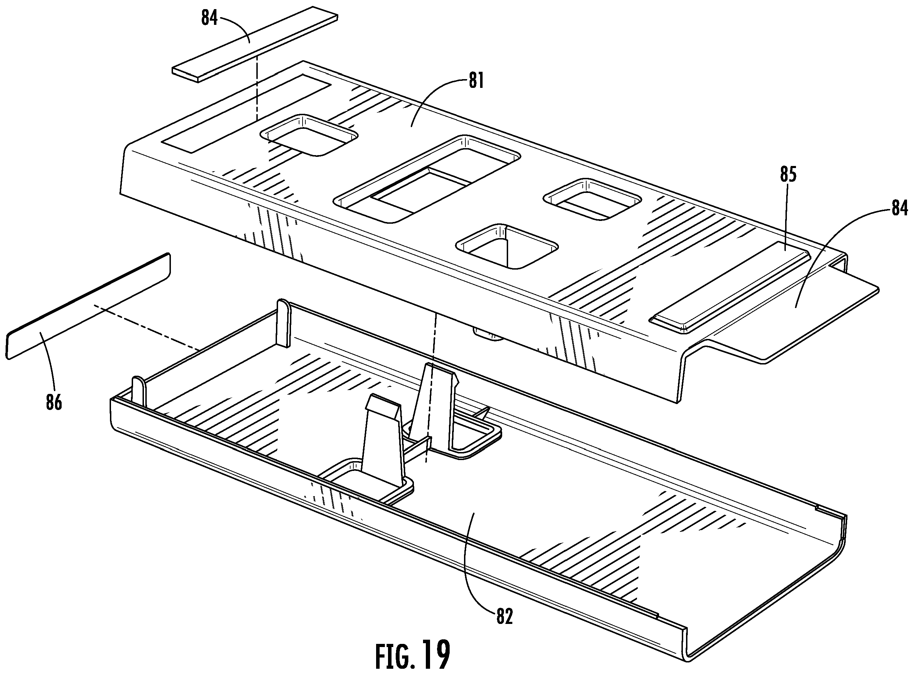

Described now are exemplary embodiments of the present invention. An exemplary embodiment of the computer docking station is depicted in Figures 1-19. Referring to Figures 1-5, the computer docking station **1** can comprise an upper dock subassembly **20** connected to a lower dock subassembly **40.** The upper dock subassembly **20** is designed to house active data port connectors (i.e., frequently connected/disconnected), while the lower dock subassembly **40** is designed to house passive data port connectors (i.e., infrequently connected/disconnected). The upper dock subassembly **20** can include a data port hub **21,** a monitor arm mount **29,** and a bracket **25.** The monitor arm mount **29** is preferably attached or integrated into the top of the data port hub **21,** while the bracket **25** is preferably attached to the rear or bottom of the data port hub **21.** The lower dock subassembly **40** can include a lower subassembly printed circuit board assembly (PCBA) **45** positioned within a lower dock housing **41.** A means for securing the lower dock subassembly 40 to the bottom of a work surface **100** can comprise a clamp support or bracket **42** and a screw **43.** The lower dock housing **41** and clamp support **42** can be attached to the bracket **25** of the upper dock subassembly **20** with one or more fasteners. Meanwhile, the screw **43** is threadingly engaged with the clamp support **42.** In order to secure the computer docking station **1** to a work surface or table **100,** the user can rotate the screw **43** until the screw's distal end comes into contact with the underside of the work surface **100.** In a preferred embodiment, the lower dock housing **41** of the lower dock subassembly **40** is attached to the bracket **25** of the upper dock subassembly **20** with a sufficient space in-between to accommodate a work surface **100** of varying thicknesses.

A variety of alternative mechanisms can be utilized to mount the lower dock subassembly **40** and the upper dock subassembly **20** to the work surface. For example, in a first alternative embodiment, the clamp support **42** and screw **43** can be replaced with a fixed bracket that permanently attaches the computer docking station **1** to the work surface. In a second alternative embodiment, the clamp support **42** and screw **43** can be replaced with a means for removably mounting the computer docking station **1** to a slat wall. In a third alternative embodiment, the computer docking station **1** can utilize separate brackets to mount the lower dock subassembly **40** and the upper dock subassembly **20** to the work surface, thereby allowing for greater flexibility in mounting locations for each subassembly. In a fourth alternative embodiment, the upper dock subassembly **20** can be secured to the work surface, while the lower dock subassembly **40** is free hanging from a flexible connector to the upper dock subassembly **20,** thereby allowing the user to quickly adjust the positioning of the lower dock subassembly **40** relative to the upper dock subassembly **20.** While Figures 1-19 depict the upper and lower dock subassemblies **20,40** positioned in a horizontal orientation, one skilled in the art will readily appreciate that either or both of the dock subassemblies **20,40** can alternatively be positioned in a vertical orientation.

The active data port connectors of the upper dock subassembly **20** can be linked to the internal components of the lower dock subassembly **40** via one or more bridge cables **6.** In a preferred embodiment, a single bridge cable **6** is utilized to connect the active data port connectors of the upper dock subassembly **20** to the internal components of the lower dock subassembly **40.** In alternative embodiments, multiple bridge cables **6** can be utilized to link the various data ports, or the bridge cable(s) **6** can be replaced with wireless connection.

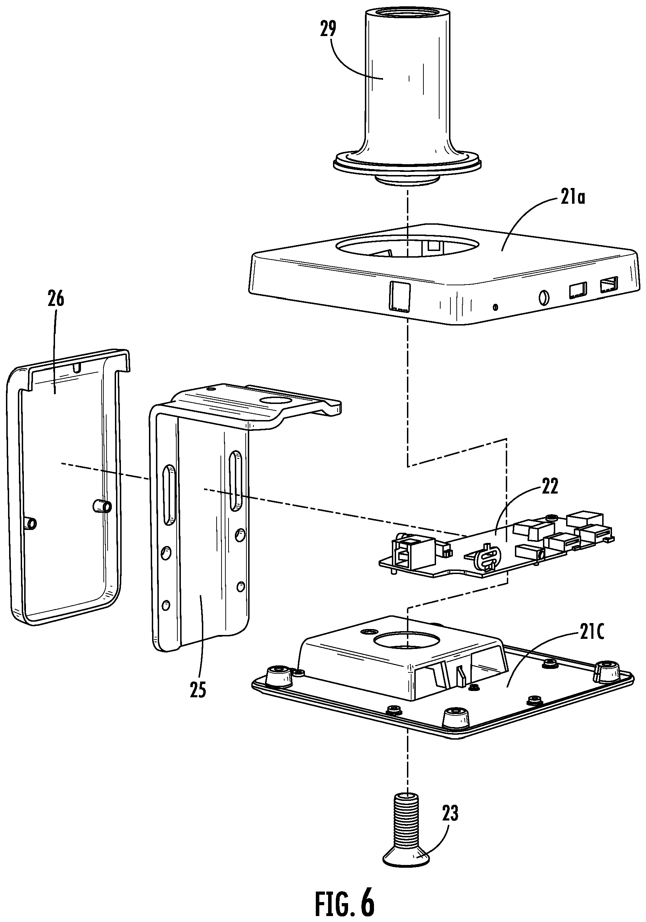

Referring now to Figures 6-10, the upper dock subassembly **20** can feature a data port hub **21,** a monitor arm mount **29,** a bracket **25,** and one or more data ports **32-36.** The data port hub **21** can comprise a hub cover **21a** attached to a hub base **21c** for housing an upper subassembly printed circuit board assembly (PCBA) **22,** while also providing sufficient rigidity to support the weight of one or more monitors attached to the upper dock subassembly **20.** The hub cover **21a** the hub base **21c,** the bracket **25,** and the monitor arm mount **29** can be connected with one or more fasteners **23,** can be molded with snap-fit joints, or can be attached by any other means known in the art. In certain embodiments, a bracket cover **26** can be utilized to secure and hide the one or more bridge cables **6** linking the active data port connectors of the upper dock subassembly **20** to the internal components of the lower dock subassembly **40.**

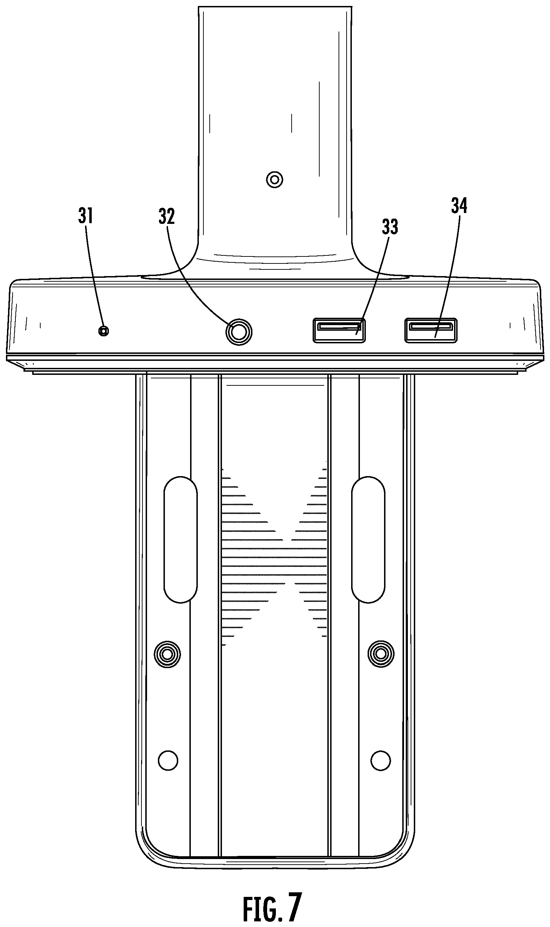

In the exemplary embodiment depicted in Figures 7-10, the upper subassembly PCBA **22** can feature an indicator light **31** and one or more data ports **32-36.** The indicator light **31** functions to provide the user feedback regarding the operation status of the computer docking station **1.** Data port **32** can be an audio combo jack port, while data ports **33, 34** and **35** preferably are USB-A 3.0 SS (SuperSpeed, 0.9A) data ports which allow users to connect USB peripherals and mobile devices to the user's laptop via the computer docking station **1.** In an exemplary embodiment, data port **33** is a USB 3.0 BC 1.2 (1.5A) charging port, while data ports **34** and **35** are USB-C ports capable to be used for both connectivity and power. Data port **36** can comprise a USB 3.0 B-Type upstream connector port designed to be linked to the user's laptop. The USB 3.0 B-Type upstream connector port **36** allows for the transfer of data, video and audio information between the computer and peripherals through the computer docking station **1,** as well as the transfer of power when USB C-Type connector cables are utilized. In alternative embodiments, one skilled in the art will readily acknowledge that the locations and types of data ports **32-36** can easily be modified to adapt to changing technologies and uses of the data ports. For example, the back of the data port hub can be used to accommodate one or more of the data ports **32-36.** In certain embodiments the upper subassembly PCBA **22** can also feature a wireless charging platform for mobile devices.

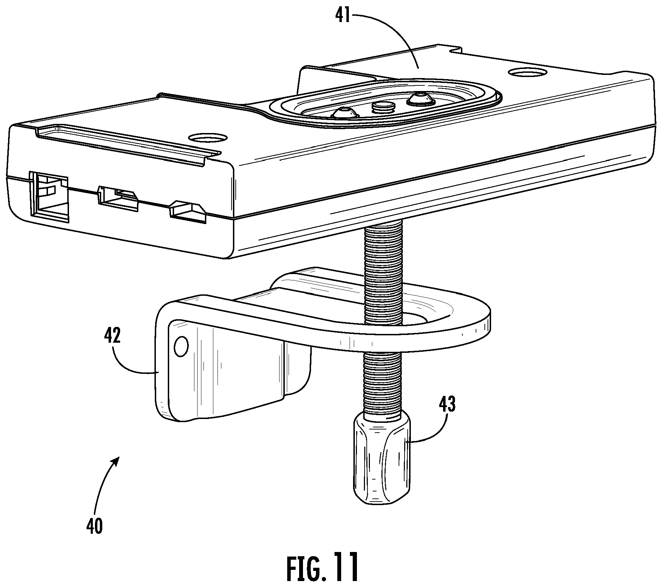

Referring now to Figures 11-16, the lower dock subassembly **41** of the lower dock subassembly **40** can comprise a clamp foot **41a,** a top member **41b** and a bottom member **41c.** The clamp foot **41a** is attached to the top member **41b,** while the top member **41b** is attached to the bottom member **41c** to provide a housing for the lower subassembly PCBA **45.** The clamp foot **41a,** the top member **41b** and the bottom member **41c** can be connected with one or more fasteners **49,** can be molded with snap-fit joints, or can be attached by any other means known in the art.

In the exemplary embodiment depicted in Figures 7-10, the lower subassembly PCBA **45** features one or more power and data ports **51-58.** Data port **51** can comprise a RJ45 100 Mbit Ethernet connector for providing the user's laptop with a wired internet connection through the computer docking station **1.** Data port **52** can comprise a Display Port connector and data port **53** can comprise an HDMI connector for allowing monitor(s) to be connected to the computer docking station **1.** Alternatively, these data port could be a DVI, HDMI or USB-C type connectors/ports. Data ports **54a-c** can be USB-A 3.0 SS (SuperSpeed, 0.9A) data ports which allow users to connect USB peripherals to the user's laptop via the computer docking station **1.** In alternative embodiments, data ports **54a-c** can be any type of USB port, including but not limited to USB 3.0 BC 1.2 (1.5A) charging ports and USB-C ports.

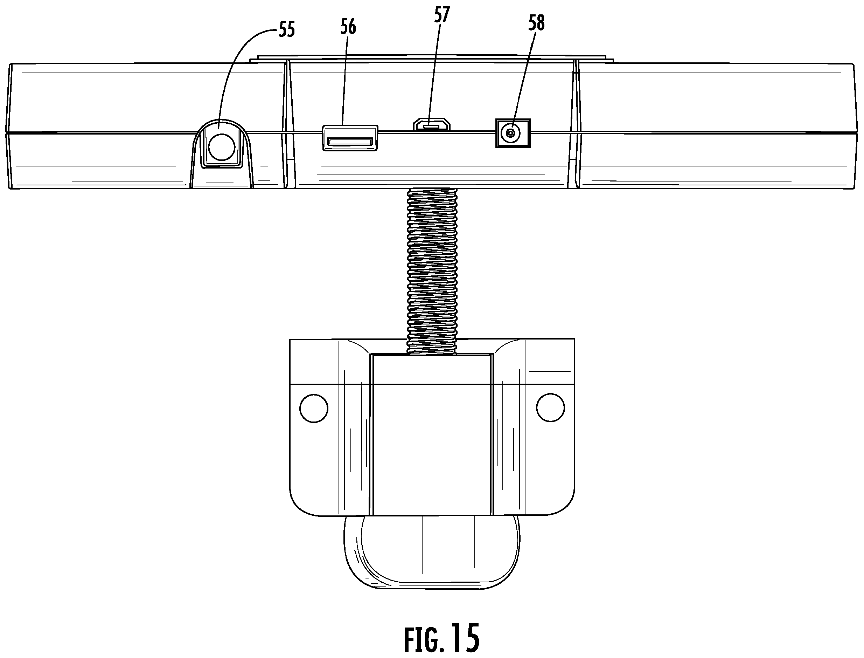

Referring now to Figure 15, in an exemplary embodiment data port **55** can comprise a DC power connector through which power is supplied to the lower dock subassembly **40.** Data port **56** can comprise USB-A 3.0 SS data bridge cable connector capable of being mated to the bridge cable **6** for transferring data between the upper subassembly PCBA **22** of the upper dock subassembly **20** and the lower subassembly PCBA **45** of the lower dock subassembly **40.** Alternatively, Data port **56** can comprise a USB-C connector or can be replaced with a wireless communication mechanism. Data port **57** can comprise a USB-A mini 3.0 audio combo bridge cable connector or a USB-C port/connector to allow the transfer of audio data between the upper dock subassembly **20** and the lower dock subassembly **40.** Lastly, data port **58** can comprise a DC power bridge cable connector, or alternatively a USB-C connector, for providing power to the upper dock subassembly **20** and attached laptop.

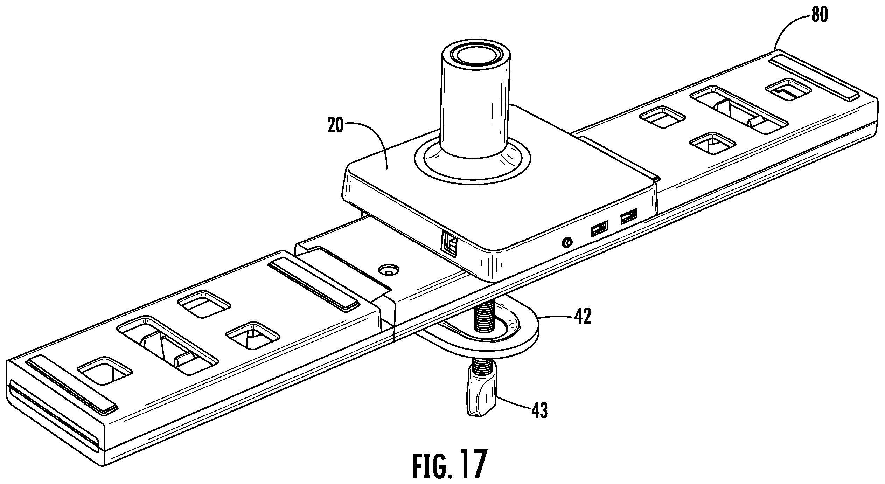

Referring now to Figures 17-19, the computer docking station **1** can further comprise a cable management enclosure **80** attached to either, or both, sides of the lower dock subassembly **40.** The cable management enclosure **80** features an upper cable housing **81** mated with snap joints to a lower lid **82.** The upper housing **81** preferably has three internal hooks allowing the user to wrap any cable slack around the hooks for storage within the cable management enclosure **80.** Adhesive or mechanical-based fastening strips **84** (e.g., hook and loop fasteners) can be utilized to secure the upper cable housing **81** to the undersurface of the work surface **100.** The cable management enclosure **80** may also contain an alignment tab **85** for aligning and securing the cable housing **81** to the lower dock subassembly **41** of the lower dock subassembly **40.** A flexible hinge insert **86** can be utilized to releasably connect the lower lid **82** to the cable housing **81** so as to allow a user to access the cable management enclosure **80** by folding down the lower lid **82.**

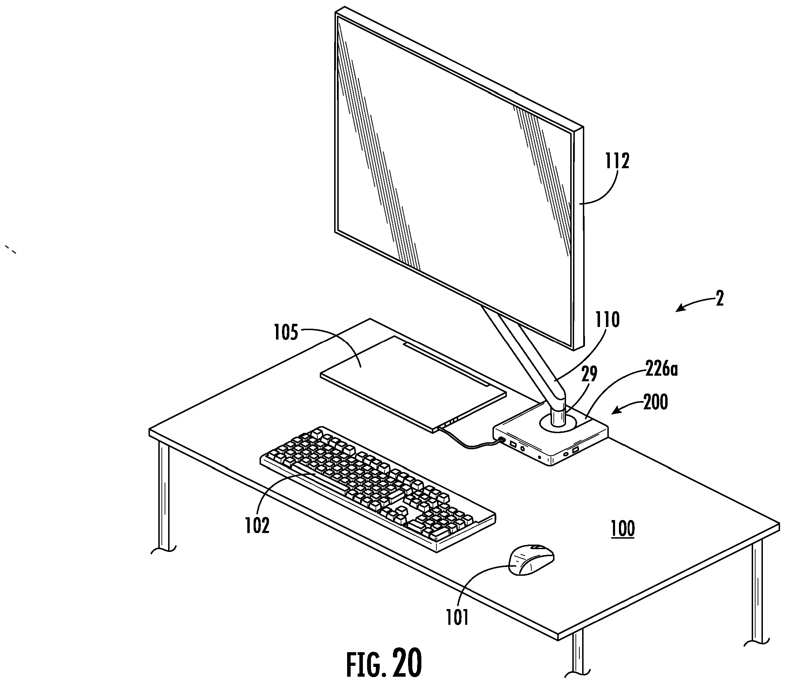

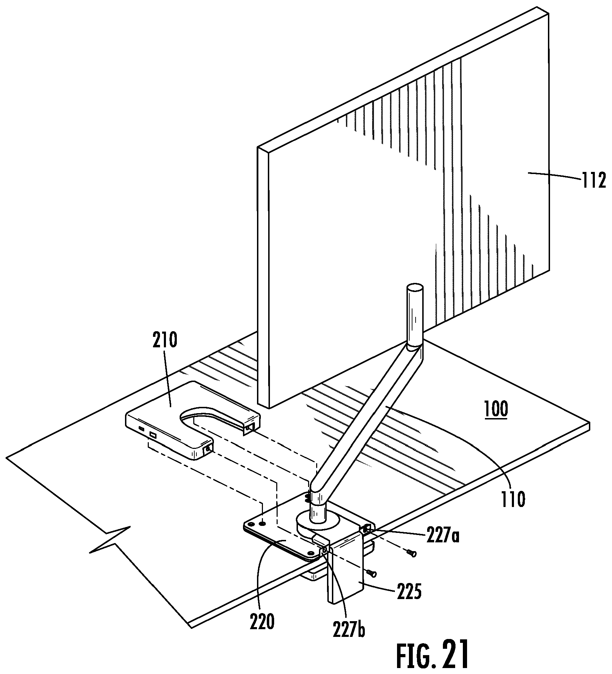

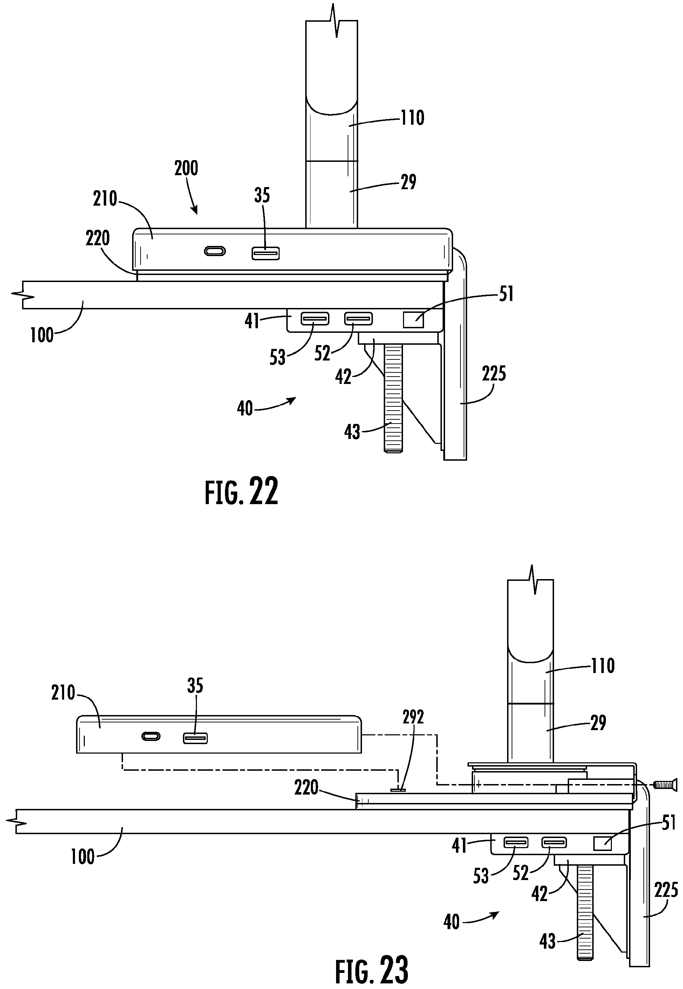

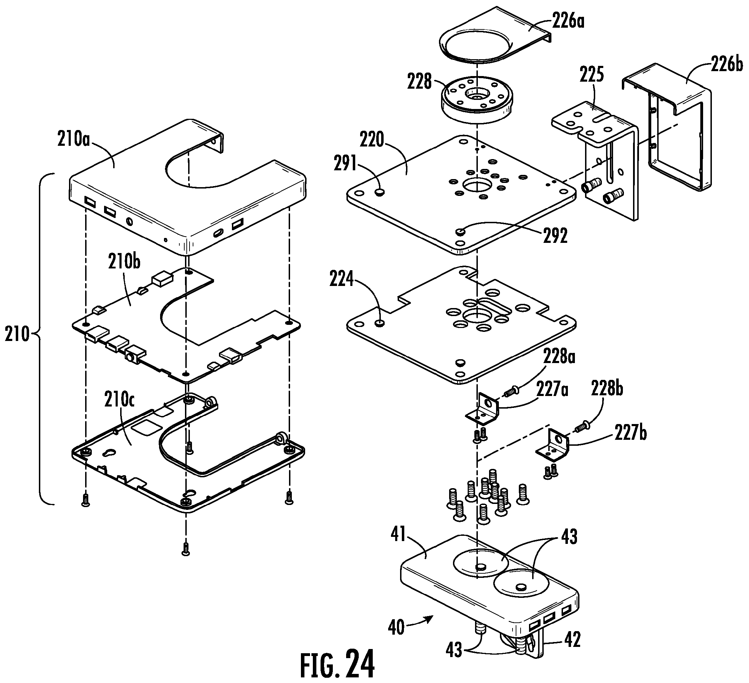

Referring to Figures 20-24, an alternative embodiment of a computer docking station **2** is depicted. The computer docking station **2** features an upper dock subassembly **200** having a removable data port hub **210.** By having a data port hub **210** that can be selectively detached from the remainder of the upper dock subassembly **200,** the computer docking station **2** provides users the benefit of more easily removing the upper subassembly printed circuit board assembly (PCBA) **210b** (e.g., for repair or replacement) without having to disassemble the entire computer docking station and attached peripherals. The computer docking station 2 also provides users the benefit of more easily removing the upper subassembly PCBA) 210b for updating the hardware or firmware and allowing a migration path for when technology is obsoleted/outdated and need to be replaced with new standards.

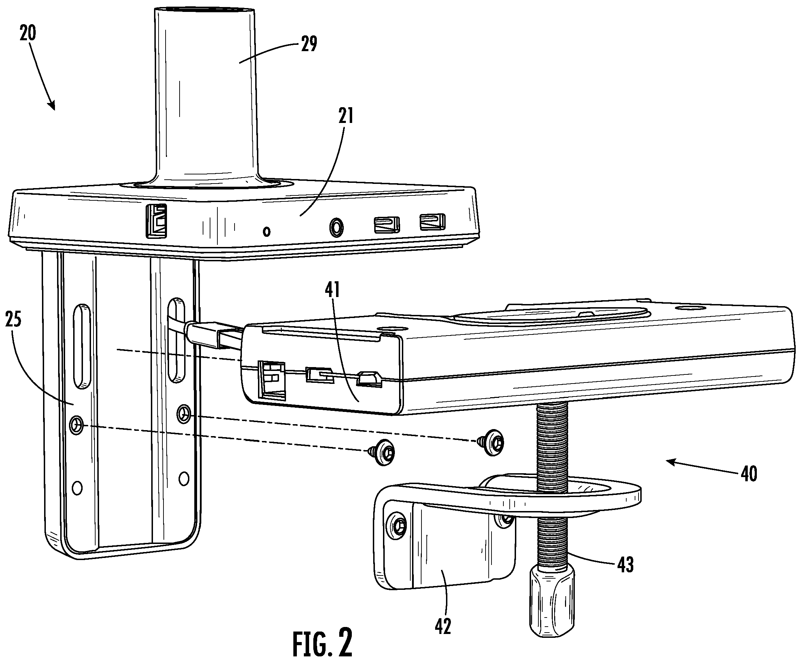

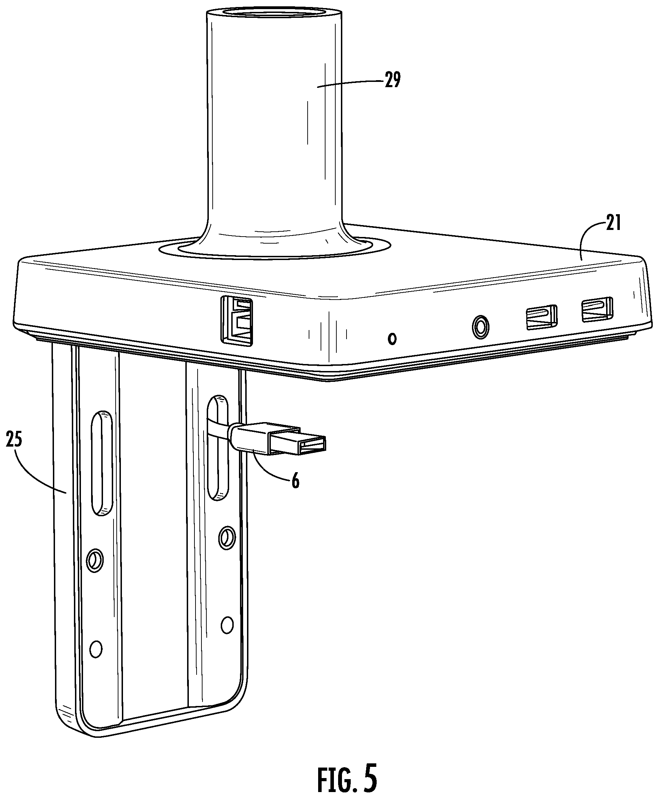

The computer docking station **2** depicted in figures 20-24 may comprise an upper dock subassembly **200** operatively connected to a lower dock subassembly **40.** The upper dock subassembly **200** is designed to house active data port connectors (i.e., frequently connected/disconnected ports such as data ports **32-36**), while the lower dock subassembly **40** is designed to house passive data port connectors (i.e., infrequently connected/disconnected). The upper dock subassembly **200** can be operatively connected to the lower dock subassembly via a bridge cable **6** (e.g., see Figs. 2 and 5) or via a wireless connection. In the embodiment depicted in Figures 20-24, a bracket **225** is utilized to connect the upper dock subassembly **200** to the lower dock subassembly **40.** A clamp or other known attachment mechanism can be utilized to secure both subassemblies to a work surface or table **100.**

The upper dock subassembly **200** can include a removable data port hub **210** and a mounting plate **220.** The removable data port hub **210** is designed to be releasably coupled to the mounting plate **220.** A monitor arm mount **29** can be either attached to, or integrated into, the top of mounting plate **220,** while an upper portion of the bracket **225** is preferably attached to the rear or bottom of the mounting plate **220.** A monitor arm **110** can be connected to the monitor arm mount **29,** with one or more computer monitors **112** mounted to the monitor arm **110.** A mouse **101,** a keyboard **102,** a laptop **105** and other computer peripherals may be connected to the active data port connectors (data ports **32-36**) of the removable data port hub **210 or** lower dock subassembly **40.**

Still referring to Figures 20-24, the removable data port hub **210** can comprise a hub cover **210a,** an upper subassembly PCBA **210b,** and a hub base **210c.** Alternatively, the removable data port hub **210** can comprise a hub cover **210a** and an upper subassembly PCBA **210b.** One or more fasteners can be used to connect the hub cover **210a** to the hub base **210c,** thereby forming a housing for the upper subassembly PCBA **210b.** The upper subassembly PCBA **210b** can comprise one or more data ports **32-36** accessible through apertures in the hub cover **210a.** In one embodiment, a bracket **225** and first and second L-shaped lock tabs **227a, 227b** can be attached to the mounting plate **220.** Both the bracket **225** and the first and second L-shaped lock tabs **227a, 227b** can be attached to the mounting plate **220** via fasteners or other means known in the art. A pad **224** optionally can be mounted below the mounting plate **220** to protect the work surface **100.** A spacer **228** optionally can be mounted above the mounting plate **220** to provide a mounting point for the monitor arm mount **29.** An upper bracket cover **226a** and a lower bracket cover **226b** can be positioned adjacent to the bracket **225** to cover the fasteners connecting the underlying components of the upper dock subassembly **220.**

The lower dock subassembly **40** depicted in Figures 20-24 is similar in function and design to the lower dock subassembly **40** depicted in Figures 1-19. The lower dock subassembly **40** can include a lower subassembly PCBA **45** positioned within a lower dock housing **41.** A means for securing the lower dock subassembly 40 to the bottom of a work surface **100** can comprise a clamp support or bracket **42** and one or more screws **43.** The lower dock subassembly **41** and clamp support **42** can be attached to the lower portion of the bracket **225** with one or more fasteners. Meanwhile, the screws **43** can each have a clamp foot **43** attached to their distal end for engaging the bottom of the work surface **100.** In order to secure the computer docking station **2** to a work surface or table **100,** the user can threadingly engage the screws **43** with the threaded apertures in the clamp support **42** and then rotate the screw **43** until the screw's distal end comes into contact with the underside of the work surface **100.**

The removable data port hub **210** can be mated to the mounting plate **220** by placing the data port hub **210** adjacent to the mounting plate **220** and then causing the pins **291, 292** to engage the eye portion of the respective key slots **211, 212.** To lock the data port hub **210** into position, the data port hub **210** can then be slid towards the bracket **225** to cause the pins **291, 292** to move into the slot portion of the key slots **211, 212,** thereby mating the data port hub **210** to the mounting plate **220.** To lock the data port hub **210** into the mated position, the first and second fasteners **228a, 228b** can be extended through apertures in the first and second lock tabs **227a, 227b** to engage threaded apertures in the rear portion of the hub cover **210.** The active data port connectors of the upper dock subassembly **200** then can be linked to the internal components of the lower dock subassembly **40** by coupling the bridge cable **6** to the upper subassembly PCBA **210b** of the removable data port hub **210.** In alternative embodiments, multiple bridge cables **6** can be utilized to link the various data ports, or the bridge cable(s) **6** can be replaced with wireless connection.

The foregoing description and accompanying drawings illustrate the principles, exemplary embodiments, and modes of operation of the invention. However, the invention should not be construed as being limited to the particular embodiments discussed above. Many modifications of the embodiments described herein will come to mind to one skilled in the art having the benefit of the teaching presented in the foregoing descriptions and the associated drawings. Accordingly, it should be appreciated that variations to those embodiments can be made by those skilled in the art without departing from the scope of the invention.

## Claims

1. A computer docking station (1) comprising:
a) a bracket (225) having an upper portion and a lower portion;
b) an upper dock subassembly (200) coupled to the upper portion of the bracket (225) and adapted to be positioned on top of a work surface (100), the upper dock (200) subassembly comprising: a data port hub (210), wherein the data port hub (210) comprises a hub cover (210a), a hub base (210c), and an upper subassembly printed circuit board assembly (PCBA) (210b) positioned between the hub cover (210a) and hub base (210c), wherein the upper subassembly PCBA (210b) comprises one or more active data ports (32-36); and
c) a lower dock subassembly (40) coupled to the lower portion of the bracket (225) and adapted to be positioned beneath the work surface (100), the lower dock subassembly (40) comprising a lower subassembly printed circuit board assembly (PCBA) (45) positioned within a lower dock housing (41), wherein the lower subassembly PCBA (45) comprises one or more passive data ports (51-58),
**characterized in that** the upper dock assembly (200) further comprises a mounting plate (220) having a top surface and a bottom surface, wherein the data port hub (210) of the upper dock subassembly (200) is releasably coupled to the top surface of the mounting plate (220), and the bottom of the mounting plate (220) is coupled to the upper portion of the bracket (225).

2. The computer docking station of claim 1, wherein the mounting plate (220) comprises first and second pins (291, 292) protruding from the top surface of the mounting plate (220).

3. The computer docking station of claim 2, wherein the hub base (210c) comprises first and second key slots (211, 212), wherein the first key slot (211) is adapted to receive the first pin (291) and the second key slot (212) is adapted to receive the second pin (291) when the removable data port hub (210) is positioned adjacent to the mounting plate (220).

4. The computer docking station of claim 3, wherein the upper dock subassembly (200) further comprises first and second L-shaped lock tabs (227a, 227b), wherein the first and second L-shaped lock tabs (227a, 227b) each define a vertical portion and a horizontal portion, wherein the horizontal portions of the first and second L-shaped lock tabs are each attached to a rear portion of the mounting plate, and wherein the vertical portions of the first and second L-shaped lock tabs (227a, 227b) are each releasably attached to a rear portion of the hub cover (210a) of the data port hub (210).

5. The computer docking station of claim 1, wherein the upper dock subassembly (200) further comprises a monitor arm mount (29) attached to the mounting plate (220).

6. The computer docking station of claim 5, wherein the upper dock subassembly (200) further comprises a spacer (228) positioned between the monitor arm mount (29) and the mounting plate (220).

7. The computer docking station of claim 1, wherein the lower dock subassembly (40) further comprises a clamp support (42) attached to the lower portion of the bracket (225).

## Patentansprüche

1. Computerdockingstation (1), die umfasst:
a) eine Halterung (225) mit einem oberen Abschnitt und einem unteren Abschnitt;
b) eine obere Dock-Unteranordnung (200), die mit dem oberen Abschnitt der Halterung (225) gekoppelt und so ausgelegt ist, dass sie auf einer Arbeitsfläche (100) positioniert werden kann, wobei die obere Dock-Unteranordnung (200) umfasst: einen Datenport-Hub (210), wobei der Datenport-Hub (210) eine Hub-Abdeckung (210a), eine Hub-Basis (210c) und eine Schaltkarte (Printed Circuit Board Assembly, PCBA) (210b) der oberen Unteranordnung umfasst, die zwischen der Hub-Abdeckung (210a) und der Hub-Basis (210c) angeordnet ist, wobei die obere Unteranordnung PCBA (210b) einen oder mehrere aktive Datenanschlüsse (32-36) umfasst; und
c) eine untere Dock-Unteranordnung (40), die mit dem unteren Abschnitt der Halterung (225) gekoppelt und so ausgelegt ist, dass sie unterhalb der Arbeitsfläche (100) positioniert werden kann, wobei die untere Dock-Unteranordnung (40) eine Schaltkarte (PCBA) (45) der unteren Unteranordnung umfasst, die innerhalb eines unteren Dockgehäuses (41) positioniert ist, wobei die PCBA (45) der unteren Unteranordnung einen oder mehrere passive Datenanschlüsse (51-58) umfasst,
**dadurch gekennzeichnet, dass** die obere Dockanordnung (200) ferner eine Montageplatte (220) mit einer Oberseite und einer Unterseite umfasst, wobei der Datenanschluss-Hub (210) der oberen Dock-Unteranordnung (200) lösbar mit der Oberseite der Montageplatte (220) gekoppelt ist und die Unterseite der Montageplatte (220) mit dem oberen Abschnitt der Halterung (225) gekoppelt ist.

2. Computerdockingstation nach Anspruch 1, wobei die Montageplatte (220) einen ersten und einen zweiten Stift (291, 292) umfasst, die aus der Oberseite der Montageplatte (220) herausragen.

3. Computerdockingstation nach Anspruch 2, wobei die Hub-Basis (210c) einen ersten und einen zweiten Schlüsselschlitz (211, 212) umfasst, wobei der erste Schlüsselschlitz (211) zur Aufnahme des ersten Stifts (291) und der zweite Schlüsselschlitz (212) zur Aufnahme des zweiten Stifts (291) ausgelegt ist, wenn der abnehmbare Datenport-Hub (210) benachbart zur Montageplatte (220) positioniert ist.

4. Computerdockingstation nach Anspruch 3, wobei die obere Dock-Unteranordnung (200) ferner erste und zweite L-förmige Verriegelungslaschen (227a, 227b) umfasst, wobei die ersten und zweiten L-förmigen Verriegelungslaschen (227a, 227b) jeweils einen vertikalen Abschnitt und einen horizontalen Abschnitt definieren, wobei die horizontalen Abschnitte der ersten und zweiten L-förmigen Verriegelungslaschen jeweils an einem hinteren Abschnitt der Montageplatte befestigt sind, und wobei die vertikalen Abschnitte der ersten und zweiten L-förmigen Verriegelungslaschen (227a, 227b) jeweils lösbar an einem hinteren Abschnitt der Hubabdeckung (210a) des Datenport-Hubs (210) befestigt sind.

5. Computerdockingstation nach Anspruch 1, wobei die obere Dock-Unteranordnung (200) ferner eine Monitorarmhalterung (29) umfasst, die an der Montageplatte (220) befestigt ist.

6. Computerdockingstation nach Anspruch 5, wobei die obere Dock-Unteranordnung (200) ferner einen Abstandshalter (228) umfasst, der zwischen der Monitorarmhalterung (29) und der Montageplatte (220) positioniert ist.

7. Computerdockingstation nach Anspruch 1, wobei die untere Dock-Unteranordnung (40) ferner eine Klemmhalterung (42) umfasst, die an dem unteren Abschnitt der Halterung (225) befestigt ist.

## Revendications

1. Station d'accueil d'ordinateur (1), comprenant :
a) une équerre (225) ayant une partie supérieure et une partie inférieure ;
b) un sous-ensemble d'accueil supérieur (200) couplé à la partie supérieure de l'équerre (225) et adapté pour être positionné par-dessus une surface de travail (100), le sous-ensemble d'accueil supérieur (200) comprenant : un concentrateur de ports de données (210), dans laquelle le concentrateur de ports de données (210) comprend un couvercle de concentrateur (210a), une base de concentrateur (210c), et un ensemble carte de circuit imprimé (« Printed Circuit Board Assembly », PCBA) de sous-ensemble supérieur (210b) positionné entre le couvercle de concentrateur (210a) et la base de concentrateur (210c), dans laquelle le PCBA de sous-ensemble supérieur (210b) comprend un ou plusieurs ports de données actifs (32-36) ; et
c) un sous-ensemble d'accueil inférieur (40) couplé à la partie inférieure de l'équerre (225) et adapté pour être positionné en dessous de la surface de travail (100), le sous-ensemble d'accueil inférieur (40) comprenant un ensemble carte de circuit imprimé (PCBA) de sous-ensemble inférieur (45) positionné à l'intérieur d'un logement d'accueil inférieur (41), dans laquelle le PCBA de sous-ensemble inférieur (45) comprend un ou plusieurs ports de données passifs (51-58),
**caractérisé en ce que** l'ensemble d'accueil supérieur (200) comprend en outre une plaque de montage (220) ayant une surface de dessus et une surface de dessous, dans laquelle le concentrateur de ports de données (210) du sous-ensemble d'accueil supérieur (200) est couplé de façon libérable à la surface de dessus de la plaque de montage (220), et le dessous de la plaque de montage (220) est couplé à la partie supérieure de l'équerre (225).

2. Station d'accueil d'ordinateur de la revendication 1, dans laquelle la plaque de montage (220) comprend des première et seconde goupilles (291, 292) faisant saillie à partir de la surface de dessus de la plaque de montage (220).

3. Station d'accueil d'ordinateur de la revendication 2, dans laquelle la base de concentrateur (210c) comprend des première et seconde fentes de clavetage (211, 212), dans laquelle la première fente de clavetage (211) est adaptée pour recevoir la première goupille (291) et la seconde fente de clavetage (212) est adaptée pour recevoir la seconde goupille (291) lorsque le concentrateur de ports de données amovible (210) est positionné de façon adjacente à la plaque de montage (220).

4. Station d'accueil d'ordinateur de la revendication 3, dans laquelle le sous-ensemble d'accueil supérieur (200) comprend en outre des première et seconde languettes de verrouillage en forme de L (227a, 227b), dans laquelle les première et seconde languettes de verrouillage en forme de L (227a, 227b) définissent chacune une partie verticale et une partie horizontale, dans laquelle les parties horizontales des première et seconde languettes de verrouillage en forme de L sont chacune fixées à une partie arrière de la plaque de montage, et dans laquelle les parties verticales des première et seconde languettes de verrouillage en forme de L (227a, 227b) sont chacune fixées de façon libérable à une partie arrière du couvercle de concentrateur (210a) du concentrateur de ports de données (210).

5. Station d'accueil d'ordinateur de la revendication 1, dans laquelle le sous-ensemble d'accueil supérieur (200) comprend en outre un appui de bras de moniteur (29) fixée à la plaque de montage (220).

6. Station d'accueil d'ordinateur de la revendication 5, dans laquelle le sous-ensemble d'accueil supérieur (200) comprend en outre une pièce d'espacement (228) positionnée entre l'appui de bras de moniteur (29) et la plaque de montage (220).

7. Station d'accueil d'ordinateur de la revendication 1, dans laquelle le sous-ensemble d'accueil inférieur (40) comprend en outre un support de serrage (42) fixé à la partie inférieure de l'équerre (225).
